# EUROPEAN PATENT SPECIFICATION

(11) **EP 4 374 225 B1**
(45) Date of publication and mention of the grant of the patent: **06.05.2026**
(21) Application number: 21773923.4
(22) Date of filing: 24.08.2021
(51) Int. Cl.: G03F 7/20, G06F 30/398

(54) **DEFECTIVITY QUANTIFIER DETERMINATIONS FOR LITHOGRAPHICAL CIRCUIT FABRICATION PROCESSES THROUGH OFF-TARGET PROCESS PARAMETERS**
FEHLERQUANTIFIZIERUNGSBESTIMMUNGEN FÜR LITHOGRAFISCHE SCHALTUNGSHERSTELLUNGSVERFAHREN MIT PROZESSPARAMETERN AUSSERHALB VON ZIELPARAMETERN
DÉTERMINATIONS DE QUANTIFICATEURS DE DÉFAUTS POUR DES PROCÉDÉS DE FABRICATION DE CIRCUITS LITHOGRAPHIQUES PAR L'INTERMÉDIAIRE DE PARAMÈTRES DE PROCÉDÉ HORS CIBLE

(43) Date of publication of application: 29.05.2024
(73) Proprietor: Siemens Industry Software Inc., Plano, TX 75024-6612 (US)
(72) Inventor: LATYPOV, Azat, San Jose, California 95135 (US); KIM, Young Chang, San Jose, California 95130 (US); FENGER, Germain Louis, Gladstone, Oregon 97027 (US)
(74) Representative: HKW Intellectual Property PartG mbB
(86) International application number: PCT/US2021/047243
(87) International publication number: WO 2023/027689

(56) References cited:
- WO-A1-2017/091317
- WO-A1-2020/114684
- WO-A1-2021/037484
- US-A1- 2021 202 204

## Description

### BACKGROUND

Electronic circuits, such as integrated circuits, are used in nearly every facet of modern society, from automobiles to microwaves to personal computers and more. Design of circuits may involve many steps, known as a "design flow." The particular steps of a design flow are often dependent upon the type of circuit being designed, its complexity, the design team, and the circuit fabricator or foundry that will manufacture the circuit. Electronic design automation (EDA) applications support the design and verification of circuits prior to fabrication. EDA applications may implement various procedures, e.g., functions, tools, or features to analyze, test, or verify a circuit design at various stages of the design flow.

Further prior art may be found in WO 2020 / 114 684 A1 disclosing a method for analyzing a process, the method including: obtaining a multi-dimensional probability density function representing an expected distribution of values for a plurality of process parameters; obtaining a performance function relating values of the process parameters to a performance metric of the process; and using the performance function to map the probability density function to a performance probability function having the process parameters as arguments.

### BRIEF DESCRIPTION OF THE DRAWINGS

Certain examples are described in the following detailed description and in reference to the drawings.
Figure 1 shows an example of a computing system that supports defectivity quantifier determinations through off-target process parameters for lithographical circuit fabrication processes.
Figure 2 shows an example determination of defectivity quantifiers for a lithographical circuit fabrication process performed with off-target values for process parameters.
Figure 3, not forming part of the claimed subject matter, exemplary shows an example extrapolation of a defectivity quantifier for a lithographical circuit fabrication process performed with target values for process parameters from determined defectivity quantifiers for the lithographical circuit fabrication process performed with off-target values for the process parameters.
Figure 4 shows an example of logic that a system may implement to support defectivity quantifier determinations through off-target process parameters for lithographical circuit fabrication processes.
Figure 5 shows an example of a computing system that supports defectivity quantifier determinations through off-target process parameters for lithographical circuit fabrication processes.

### DETAILED DESCRIPTION

In design flows for integrated circuits (ICs), a layout design may be derived from an electronic circuit design. The layout design may comprise an IC layout, an IC mask layout, or a mask design. In particular, the layout design may be a representation of an IC in terms of planar geometric shapes that correspond to the patterns of metal, oxide, or semiconductor layers which make up the components of the IC. The layout design can be for entire chip or a portion of a full-chip layout design.

Lithography is a process used to manufacture electronic circuits in which light is used to transfer a geometric pattern from a photomask, based on the layout design, to a silicon substrate coated by a photo-sensitive resist material (photoresist). One common family of photoresists is composed of entangled polymer chains. The polymer may contain certain functional groups which become modified due to chemical reactions caused by exposure to light (deprotection) and hence affects the polymer's solubility during development, thus creating a mask for the subsequent etching process. Various types of lithographical circuit fabrication processes are possible today, including deep ultraviolet (DUV) lithography or extreme ultraviolet (EUV) lithography. In DUV or EUV lithography, stochastic phenomena may manifest during fabrication processes, such as line edge roughness or critical dimension (CD) nonuniformity.

Stochastic effects may refer to random events or effects during fabrication that occur by chance in lithographical processes. Stochastic effects can cause pattern roughness or unintended characteristics in manufactured ICs. Different stochastic effects in lithographical fabrication processes can impact IC manufacture differently, and stochastic metrics may refer to any quantification of a stochastic effect. Examples of stochastic effects include line-edge roughness, sidelobe printing, sub-resolution assist feature (SRAF) printability, and others. In more extreme cases, stochastic effects may lead to circuit defects, e.g., stochastic pinching or bridging of the patterned features, resulting in potential failure of the electronic circuit. Other examples of stochastic-induced defects that can occur due to stochastic effects include ling breaks, missing contacts (also referred to as vias), kissing vias (e.g., merged contact holes), and more.

DUV, EUV, or other lithographical circuit fabrication processes may be subject to any number of random stochastic effects of other defectivity phenomena that can impact the yield of circuit fabrication processes. Stochastic randomness may affect various parts of the layout design, such as features in the layout design intended to be printed and features in the layout design not intended to be printed. To provide yet another example, SRAFs are auxiliary features (e.g., dark or bright areas on the photomask) added typically in the vicinity of main features to be printed through lithographical fabrication processes. The main features are intended to print elements of an IC on the wafer, usually shaped similarly to the main feature (e.g., a via, a contact hole, or an interconnect wire). The SRAFs are designed so that they do not print themselves on the wafer, but help to make the printed main features to be closer to the target shapes and to be less sensitive to the perturbations of the lithographic process parameters (e.g., dose and focus). However, stochastic effects during manufacture may cause printing of the SRAFs onto the IC, and undesired consequence caused by stochastic randomness of lithography processes.

As used herein, a defectivity quantifier quantification of a particular process-related aspect of a lithographical circuit fabrication process can be referred to as a defectivity quantifier. As such, a defectivity quantifier may specify a quantitative value for a stochastic-induced defect, stochastic effect or metric, or any other process-related effect on a lithographical circuit fabrication process. While it can be understood that circuit defectivity can be attributed to stochastic effects or other lithography-process effects, reliably determining defectivity quantifiers can be challenging due to low occurrence rates of stochastic-induced defects or stochastic effects when circuit patterns are fabricated at optimal process conditions. Such production process parameters may be designed to minimize or otherwise reduce stochastic effects (e.g., by optimizing dose and focus values).

For example, failure rates may be caused by particular stochastic effects in circuits manufactured at high-volume process conditions, and a defectivity quantifier that specifies a quantitative value for such a failure rate may be as low as 1 failure in 10 billion lithographical fabrications of a given layout design, and at times even lower. Express and brute-force determinations of defectivity quantifiers of such failure rates, stochastic metrics, or any other defectivity measure for lithography fabrication processes performed at optimal or high-volume process conditions may require analyzing tens or hundreds of billions of instances of a given pattern, potentially more, in order to properly quantify corresponding defectivity rates at these optimal process conditions.

As an illustrative example, experimental measurements to determine failure rates of stochastic-induced defects may involve fabricating billions of instances of a given lithographical pattern at target process conditions (e.g., high-yield or optimal process conditions). Then, the physically manufactured circuits can be examined, inspected, or analyzed via processing to determine defectivity rates. For example, high-resolution images, optical inspection images, scanning electronic microscopy (SEM) images, atomic force microscopy (AFM) images, or any optical image of the fabricated pattern instances may be scanned and analyzed using complex imaging techniques to count defects, failures, or other identified stochastic effects in order to quantify a defectivity measure of defect counts, circuit failures, or other stochastic effect occurrences. As another example, rigorous Monte Carlo simulations may be performed to simulate fabrication of billions of instances of a given lithographical pattern using target process conditions (e.g., high-yield or optimal process conditions). Then, counts of defects or stochastic effect occurrences can be performed from the simulated circuit fabrications. Accurate simulations to properly model stochastic effects may require significant computational resources to perform. As such, quantification of defectivity measures for high-yield lithography processes can be challenging and resource-intensive.

Moreover, stochastic-induced defects or other lithography process effects may be pattern-specific, and thus each different layout design (and corresponding photomask or layout pattern) may require separate quantification. Brute-force techniques to directly quantify stochastic effects for production-level process parameters may thus require significant physical or computation resources. Reliably quantification of defectivity measures for lithographical circuit fabrication processes performed at ideal process conditions may require fabricating or simulation tens or hundreds of billions of pattern instances. Such extensive resource commitment and quantification latencies may not be tenable, feasible, or even possible in modern IC design timeframes, which may inevitably reduce capabilities to accurately assess lithographical circuit fabrication processes or properly calibrate lithographic stochastic models for high-yield process conditions.

The present invention, which is defined in the appended claims, provides systems, methods, devices, and logic in support of defectivity quantifier determinations through off-target process parameters for lithographical circuit fabrication processes. The defectivity quantifier technology described herein may provide capabilities to determine defectivity quantifiers for stochastic-induced defects, various stochastic metrics, or any other process-related defectivity measure for target process conditions. The described defectivity quantifier technology may do so without having to expressly or directly simulate or perform lithographical circuit fabrication processes at target process conditions (at which stochastic-induced defects or stochastic effects are incredibly rare). Instead, the defectivity quantifier technology determines off-target values for any number of selected process parameters of a lithographical circuit fabrication process, and defectivity quantifiers can be determined for the lithographical circuit fabrication process performed with off-target values for the selected process parameters.

In modifying the process conditions for analysis of a lithographical circuit fabrication process, the defectivity quantifier technology presented herein may analyze circuit patterns with off-target process conditions that increase rates at which stochastic-induced defects, stochastic effects, or other process-related defects occur in circuit fabrication (e.g., physical manufacture or simulated fabrication). Doing so allows for the determination of defectivity quantifiers for off-target process conditions with decreased computational or resource strain as compared to defectivity quantifiers at high-volume process conditions. The defectivity quantifiers determined for off-target process conditions can be used as an indirect measure of defectivity quantifiers performed at target process conditions. For example, the defectivity quantifier technology presented herein supports extrapolation of defectivity quantifiers for target process conditions from the determined defectivity quantifiers for off-target process conditions.

Through the defectivity quantifier determination features described herein, defectivity quantifiers for lithographical circuit fabrication processes performed at nominal, ideal, optimal, high-volume, or any other target process conditions can be determined with increased efficiency and reduced resource consumption. Compared to conventional methods that directly measure failure rates, stochastic metrics, or any other defectivity quantifiers through measurements or simulations performed with the target process conditions, indirect determinations (e.g., extrapolation) through defectivity quantifiers determined via off-target process conditions can be performed with (at times significantly) lesser numbers of circuit fabrications or simulations. Given the ever-restrictive time constraints imposed on circuit designers to design, assess, and validate modern circuit design and fabrication processes, the defectivity quantifier determination technology presented herein may increase the efficiency by which EDA computing systems determine any number of defectivity quantifiers for layout designs, photomask patterns, and lithographical circuit fabrication processes.

These and other defectivity quantifier determination features and technical benefits according to the present disclosure are described in greater detail herein.

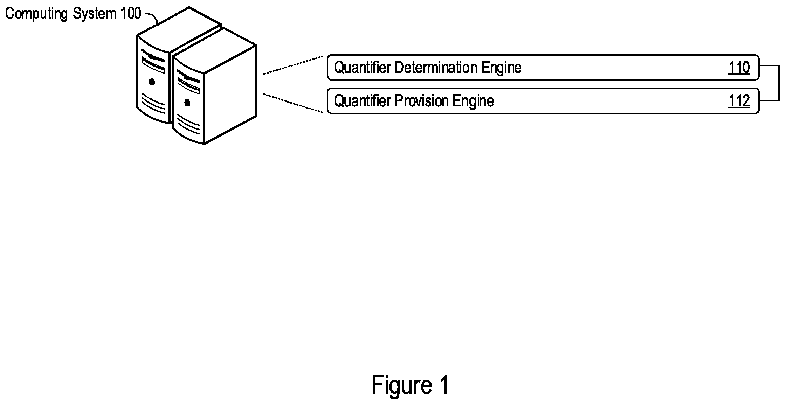

Figure 1 shows an example of a computing system 100 that supports defectivity quantifier determinations through off-target process parameters for lithographical circuit fabrication processes. The computing system 100 may take the form of a single or multiple computing devices such as application servers, compute nodes, desktop or laptop computers, smart phones or other mobile devices, tablet devices, embedded controllers, and more. In some implementations, the computing system 100 may be an EDA system that implements, supports, or hosts an EDA application or other EDA-based capabilities. In that regard, the computing system 100 may support determination of defectivity quantifiers for lithographical circuit fabrication processes, e.g., for stochastic-induced defects, stochastic metrics, or another lithographical process-related effect.

As an example implementation to support any combination of the defectivity quantifier determination features described herein, the computing system 100 shown in Figure 1 includes a quantifier determination engine 110 and a quantifier provision engine 112. The computing system 100 may implement the engines 110 and 112 (including components thereof) in various ways, for example as hardware and programming. The programming for the engines 110 and 112 may take the form of processor-executable instructions stored on a non-transitory machine-readable storage medium and the hardware for the engines 110 and 112 may include a processor to execute those instructions. A processor may take the form of single processor or multiprocessor systems, and in some examples, the computing system 100 implements multiple engines using the same computing system features or hardware components (e.g., a common processor or a common storage medium).

In operation, the quantifier determination engine 110 may determine a defectivity quantifier for a lithographical circuit fabrication process performed with a target value for a process parameter of the lithographical circuit fabrication process, and the defectivity quantifier may specify a quantitative value for a stochastic effect on the lithographical circuit fabrication process. The quantifier determination engine 110 may determine the defectivity quantifier by modifying the target value for the process parameter to obtain an off-target value for the process parameter, determining a defectivity quantifier for the lithographical circuit fabrication process performed with the off-target value for the process parameter, and extrapolating the defectivity quantifier for the lithographical circuit fabrication process performed with the target value for the process parameter from the determined defectivity quantifier for the lithographical circuit fabrication process performed with the off-target value for the process parameter. In operation, quantifier provision engine 112 may provide the determined defectivity quantifier for the lithographical circuit fabrication process performed with the target value for the process parameter for assessment of the lithographical circuit fabrication process.

These and other features of the defectivity quantifier determination technology of the present disclosure are described in greater detail next.

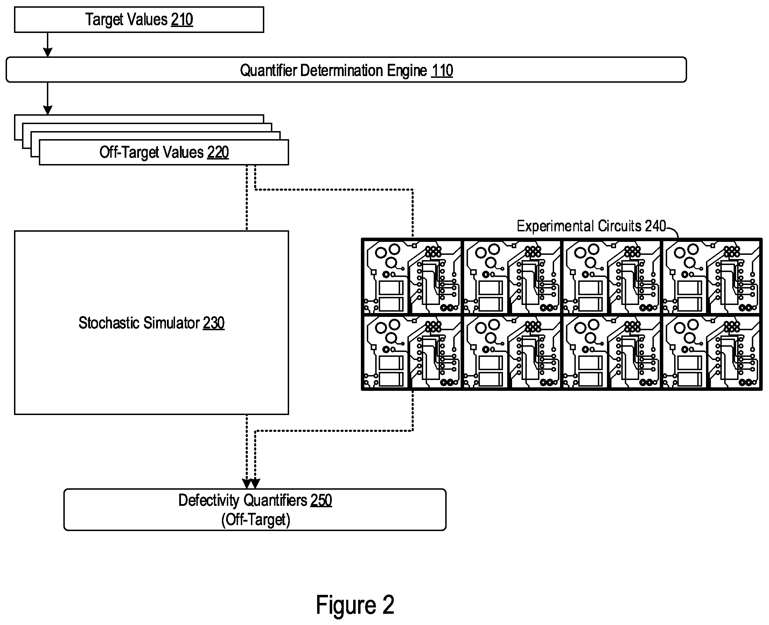

Figure 2 shows an example determination of defectivity quantifiers for a lithographical circuit fabrication process performed with off-target values for process parameters. In the example shown in Figure 2, the quantifier determination engine 110 may access or obtain target values 210 for a lithographical circuit fabrication process. The target values 210 may specify the optimal, ideal, nominal, high-volume, or production-level process conditions for a lithographical circuit fabrication process. In that regard, the target values 210 may represent the production process conditions at which a foundry or circuit manufacturer can physically manufacture ICs. Such production process conditions may be configured, designed, or specified to increase or optimize yield of fabrication processes, and can thus aim to minimize the occurrence of stochastic-induced defects or other stochastic effects.

The target values 210 may specify particular numerical values that any number of process parameters of the lithographical circuit fabrication process take, and example process parameters configurable by the target values 210 may include dose, focus, photoresist parameters, photomask dimensions of exposed features, or any additional or alterative process parameters of a lithographical circuit fabrication process. The values of the process parameters of a lithographical circuit fabrication process may also be referred to as the process conditions for the lithographical circuit fabrication process. As such, the target values 210 may specify (at least in part) an instance of process conditions that the lithographical circuit fabrication process can be performed with.

The quantifier determination engine 110 may modify any number of the target values to obtain off-target values 220 for the lithographical circuit fabrication process. The off-target values 220 may specify an instance of process conditions that differ from the process conditions specified by the target values 210. In forming the off-target values 220, the quantifier determination engine 110 may determine one or multiple selected process parameters for which to modify the target values 210 for, and the selected process parameters may comprise any determined subset of the process conditions of the lithographical circuit fabrication process.

In some implementations, the quantifier determination engine 110 may select a process parameter and modify the target value 210 for the selected process parameter based on the particular defectivity quantifier that the quantifier determination engine 110 aims to determine. For any selected process parameter, the quantifier determination engine 110 may modify the target value 210 of the selected process parameter to increase an occurrence rate of a stochastic-induced defect, a stochastic effect, or any other process-related effect that the quantifier determination engine 110 intends to quantify at target (e.g., optimal) process conditions as set by the target values 210.

As one example, the quantifier determination engine 110 may aim to determine a defectivity quantifier that specifies a quantitative value for a defect occurrence rate (e.g., a failure rate) for stochastic-induced merged via defects (also referred to as "kissing" via defects) for a lithographical circuit fabrication process performed at high-volume (e.g., target) process conditions. In this example, the quantifier determination engine 110 may select a particular process parameter of the high-volume process conditions and modify the target value 210 for the particular process condition to increase the rate at which such merged via defects occur during fabrication. The quantifier determination engine 110 may determine a dose process parameter as the selected process parameter, and modify the dose value specified in the target values 210 to increase the rate at which merged via defects occur (e.g., in this example, increasing the dose value for positive tone photoresists).

As another example, the quantifier determination engine 110 may aim to determine a defectivity quantifier that specifies a quantitative value for a defect occurrence rate (e.g., a failure rate) for missing via defects in which vias or contact holes fail to form for a lithographical circuit fabrication process performed at target process conditions. In this example, the quantifier determination engine 110 may likewise determine dose as the selected process parameter. The quantifier determination engine 110 may modify the dose value specified in the target values 210, this time by decreasing the dose value specified in the target values 210 to increase the occurrence rate of missing via defects in fabricated circuits.

In a consistent manner, the quantifier determination engine 110 may modify the target value 210 for any selected process parameter to increase the occurrence rate of a stochastic-induced defect, a stochastic effect, or any other process-related effect that the quantifier determination engine 110 intends to quantify at the process conditions set by the target values 210. As examples, the quantifier determination engine 110 may modify the target value 210 by adjusting a dose value, a focus value, a photoresist parameter value, a photomask dimension value of exposed features, or any combination thereof. In effect, the off-target values 220 formed by the quantifier determination engine 110 may specify an instance of modified or off-target process conditions for the lithographical circuit fabrication process (e.g., modified lithographic exposure-resist conditions).

The degree to which the quantifier determination engine 110 modifies the target value 210 of a selected process parameter may be configurable, adaptive, or predetermined. It may be the case that the greater the degree the quantifier determination engine 110 modifies the target value 210 for a selected process parameter, the greater the occurrence rate of a stochastic-induced defect, a stochastic effect, or any other process-related effect that the quantifier determination engine 110 intends to quantify for the target value 210. As such, the quantifier determination engine 110 may modify the target value 210 of a selected process parameter by a significant degree (e.g., beyond a threshold amount specified by a threshold percentage or numerical modification to the target value 210). Through such an increase in occurrence rates, the quantifier determination engine 110 may be able to effectively determine, quantify, or estimate defectivity quantifiers at the off-target values 220 with increased speed and efficiency (e.g., with a lesser number of experimental measurements or simulations).

In some sense, the off-target values 220 formed by the quantifier determination engine 110 can be understood as determination of off-target process conditions for stress testing the lithographical circuit fabrication process. Such stress testing conditions may represent non-ideal fabrication conditions that cause a statistically significant increase in stochastic-induced defects, stochastic effects and metrics, or other process-related defects, thus deviating significantly from optimal process conditions used in production-level fabrications designed to optimize circuit yields. That is, the off-target values 220 may represent stressed process conditions that would not be regularly used or encountered in actual IC manufacture environments, but are instead determined at threshold deviations from ideal process conditions in order to purposefully increase the occurrence rates of defects and other stochastic effects and metrics.

The quantifier determination engine 110 may determine multiple sets of off-target values 220 for a lithographical circuit fabrication process. Each set of off-target values 220 may represent a different instance of off-target process conditions for which the quantifier determination engine 110 may determine a defectivity quantifier for. To generate the multiple sets of off-target values 220, the quantifier determination engine 110 may modify the target value 210 of a selected process parameter across a range of modifications, and each different modified value of the target value 210 of a selected process parameter may be part of a different instance of off-target process conditions. As an illustrative example, the quantifier determination engine 110 may increase (or decrease) the target value 210 of a dose process parameter in multiple variations, such as across an increased numerical range or percentage range (e.g., increases of 10%, 20%, 30%, 40%, and 50% of the target value 210 for the dose process parameter). Each individual modification of the dose parameter value may form a different set of off-target values 220 at which the lithographical circuit fabrication process can be performed.

Through the generated off-target values 220, the quantifier determination engine 110 may determine defectivity quantifiers for a lithographical circuit fabrication process performed with the off-target values 220 for a selected process parameter. The quantifier determination engine 110 may determine defectivity quantifiers for the lithographical circuit fabrication process performed with the off-target values 220 for the selected process parameter through stochastic simulations, experimental measurements, or a combination of both. In the example of Figure 2, the quantifier determination engine 110 may implement or otherwise access a stochastic simulator 230 configured to simulate IC fabrication processes performed using the off-target values 220. The stochastic simulator 230 may provide, as an example, rigorous stochastic Monte Carlo simulation capabilities, and the quantifier determination engine 110 may access simulation results for fabrication of circuits at the off-target process conditions specified in the off-target values 220. Through the simulated circuit fabrications, the quantifier determination engine 110 may measure, compute, or otherwise determine defectivity quantifiers for the lithographical circuit fabrication process performed at the various instances of the off-target values 220, doing so in any suitable way as supported by modern stochastic models and simulation capabilities.

As another example, the quantifier determination engine 110 may utilize experimental measurements to determine defectivity quantifiers for the lithographical circuit fabrication process performed at the various instances of the off-target values 220. Such experimental measurements may include physical manufacture of circuit patterns through the lithographical circuit fabrication process performed at off-target process conditions specified by the off-target values 220. In the example of Figure 2, experimental circuits 240 are shown which can be manufactured using process conditions specified by the off-target values 220. Through the experimental circuits 240, the quantifier determination engine 110 may experimentally measure defectivity quantifiers for the off-target values 220. Physical measurement and inspection of the fabricated experimental circuits 240 may be performed to determine and compute corresponding defectivity quantifiers. For example, optical, AFM, SEM, or any other suitable metrology methods may be used to capture high-resolution images of the experimental circuits 240, identify occurrences of stochastic-induced defects or other stochastic effects in the experimental circuits 240, and determine the defectivity quantifiers for the off-target values 220 accordingly. As another example of experimental measurement, the quantifier determination engine 110 may support use of electrical tests (e.g., on fabricated metal or via layers) to determine defectivity quantifiers for the off-target values 220.

In any of the ways described herein, the quantifier determination engine 110 may determine defectivity quantifiers for the lithographical circuit fabrication process performed at the off-target values 220 for process parameters of the lithographical circuit fabrication process. While stochastic simulations and experimental measurements may appear similar to conventional brute-force and direct measurement methods to determine defectivity quantifiers at target (e.g., optimal) process conditions, the defectivity quantifiers for the lithographical circuit fabrication process performed at the off-target values 220 may be determined with a significantly lesser number of simulations or circuit fabrications.

This may be the case as simulations via a stochastic simulate 230 and/or experimental measurements from experimental circuits 240 need not fabricate billions or tens of billions of circuit patterns at the off-target process conditions in order to reliably determine defectivity quantifiers for the off-target values 220. Since the occurrence rate of stochastic-induced defects, stochastic effects or metrics, or other process-induced effects may be (at times significantly) increased via the off-target values 220 (e.g., at stressed conditions), the quantifier determination engine 110 need only perform, access, inspect or otherwise analyze a lesser number of circuit fabrications to reliably determine a defectivity rate or other quantifier for the off-target values 220. That is, the quantifier determination engine 110 may leverage the increased occurrence rate of defects and stochastic effects (and thus metrics) caused by the off-target values 220 in fabrication processes in order to compute, estimate, or determine defectivity quantifiers for the lithographical circuit fabrication process performed at the off-target values 220, and without having to simulate or fabricate billions or tens of billions of circuit instances as would be required to directly measure defectivity quantifiers for target (e.g., optimal or production-level) process conditions.

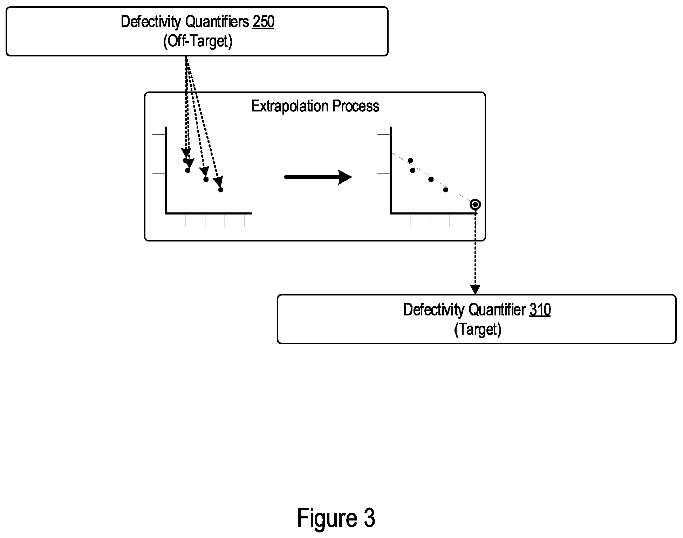

In the example shown in Figure 2, the quantifier determination engine 110 determines the defectivity quantifiers 250 for the lithographical circuit fabrication process performed at the off-target values 220. The quantifier determination engine 110 may use the defectivity quantifiers 250 determined for the lithographical circuit fabrication process performed at off-target values 220 in order to indirectly measure, estimate, or otherwise determine a defectivity quantifier for the lithographical circuit fabrication process performed at the target values 210. Example features by which the quantifier determination engine 110 may indirectly determine a defectivity quantifier for the lithographical circuit fabrication process performed at the target values 210 are described next with reference to Figure 3.

Figure 3, not forming part of the claimed invention, shows an example extrapolation of a defectivity quantifier for a lithographical circuit fabrication process performed with target values for process parameters from determined defectivity quantifiers for the lithographical circuit fabrication process performed with off-target values for the process parameters. In the example of Figure 3, the quantifier determination engine 110 extrapolates a defectivity quantifier 310 for the lithographical circuit fabrication process performed with the target values 210 from the determined defectivity quantifiers 250 for the lithographical circuit fabrication process performed with the off-target values 220.

As defectivity quantifiers 250 can be determined for multiple instances of off-target values 220 of a selected process parameter, each individual defectivity quantifier 250 determined for a specific off-target value 220 may correlate to the specific off-target value 220 for the selected process parameter. An example plot of such correlation is shown in Figure 3, in which multiple defectivity quantifiers 250 determined for instances of off-target values 220 can be plotted against the specific values of each off-target value 220 for the selected process parameter. Through such a plot, the quantifier determination engine 110 may extrapolate a value of the defectivity quantifier 310 for the specific value of the target value 210 of the selected process parameter.

In some implementations, the quantifier determination engine 110 may extrapolate the defectivity quantifier 310 by applying a logarithmic curve-fitting extrapolation process using, as an input, the determined defectivity quantifiers 250 for the lithographical circuit fabrication process performed with the off-target values 220 for a selected process parameter. In such implementations, the quantifier determination engine 110 need not know any underlying physics or lithographical relationship for the defectivity quantifiers 250 and the selected process parameter modified with off-target values 220 for the lithographical circuit fabrication process. The extrapolation may be logarithmic in that one or more axes of the plot may plotted with logarithmic intervals. Any suitable extrapolation or curve-fitting technique may be applied by the quantifier determination engine 110 to indirectly determine the defectivity quantifier 310 for the target values 210 via the determined defectivity quantifiers 250 for the off-target values 220.

As another example, the quantifier determination engine 110 may extrapolate the defectivity quantifier 310 for the lithographical circuit fabrication process performed with the target value 210 by applying a predetermined analytical dependence between the defectivity quantifier for the lithographical circuit fabrication process and the selected process parameter. Based on the underlying physics of lithographic circuit fabrication processes or any component thereof, certain stochastic effects, metrics, or induced defects may exhibit a quantifiable dependence or relationship (e.g., linear). In such cases, the quantifier determination engine 110 may extrapolate the defectivity quantifier 310 for a target value 210 of a selected process parameter by applying the determined dependence (e.g., linear dependence) to the defectivity quantifiers 250 determined for off-target values 220 of the lithographical circuit fabrication process.

In some examples, the quantifier determination engine 110 may require only a single defectivity quantifier 250 determined for an off-target value 220 of a selected process parameter, and extrapolate the defectivity quantifier 310 for the target value 310. As an illustrative example, when the analytical dependence between defectivity quantifier and selected process parameter is determined as a linear relationship with a determined slope value, the quantifier determination engine 110 may be capable of determining the defectivity quantifier 310 for the target value 210 of the selected process parameter with a single defectivity quantifier 250 determined for an off-target value 220 of the selected process parameter.

According to the ways described herein, the quantifier determination engine 110 may indirectly determine a defectivity quantifier for a lithographical circuit fabrication process performed with a target value for a selected process parameter from determined defectivity quantifiers for the lithographical circuit fabrication process performed with off-target values for the process parameter.

In some implementations, the off-target values 220 formed by the quantifier determination engine 110 may include modifications to multiple process parameters (e.g., an instance of off-target process conditions that includes a modified dose value and a modified focus value). In such cases, the quantifier determination engine 110 may extrapolate a defectivity quantifier 310 for target values 210 of the multiple process parameters through a multi-dimensional (e.g., greater than 2D) curve-fitting or extrapolation process. This may be the case, as the quantifier determination engine 110 may correlate defectivity quantifiers 250 determined off-target values 220 across multiple different process parameters, thus forming a correlation of at least 3-dimension (and possibly more) between the defectivity quantifiers 250 and the multiple process parameters modified to form the off-target values 220. Predetermined analytical dependences for one or more of the multiple process parameters may be applied to constrain the curve-fitting process (e.g., linear relationship across the dimension representing the focus process parameter)

Note that in some implementations, the quantifier determination engine 110 may specifically determine to modify the target value 210 of only a single process parameter, and thus limit curve extrapolation processes to 2D computations and analyses. Doing so may decrease the complexity of mapping defectivity quantifiers to off-target process parameter values and increase the efficiency of extrapolation processes to determine a defectivity quantifier 310 for a target value 210 of the process parameter. As such, the defectivity quantifier determination technology may increase the speed, efficiency, and feasibility of determining defectivity quantifiers for lithographical circuit fabrication processes performed at optimal or high-volume process conditions.

The quantifier provision engine 112 may provide the determined defectivity quantifier 310 for the lithographical circuit fabrication process performed with the target value 210 for the process parameter for assessment of the lithographical circuit fabrication process. In some instances, the determined defectivity quantifier 310 may be used to quantify a stochastic effect, and thus may be used as part of a stochastic model in order to assess the efficacy of various lithography processes used to manufacture ICs. As another example, the determined defectivity quantifier 310 may be used to measure efficacy of the lithographical circuit fabrication process, and a circuit designer may modify lithography processes to increase fabrication efficacy.

In any of these examples, the quantifier provision engine 112 may provide the determined defectivity quantifier 310 for assessment by transmitting, storing, communicating, or processing the determined defectivity quantifier 310 in support of such an assessment. For instance, the quantifier provision engine 112 may transmit the determined defectivity quantifier 310 to an EDA system that implements a stochastic model or configured to assess the lithographic circuit fabrication process. As another example, the quantifier provision engine 112 may provide the determined defectivity quantifier 310 by storing the defectivity quantifier 310 (either locally or remotely) at a predetermined memory or storage location for further assessment. Nearly any subsequent action may be supported by the quantifier provision engine 112 to utilize the determined defectivity quantifier 310 for assessment of the lithographical circuit fabrication process performed at target (e.g., high volume) process conditions.

While many defectivity quantifier determination features have been described herein through illustrative examples presented through various figures, the quantifier determination engine 110 and quantifier provision engine 112 may implement any combination of the defectivity quantifier determination features described herein.

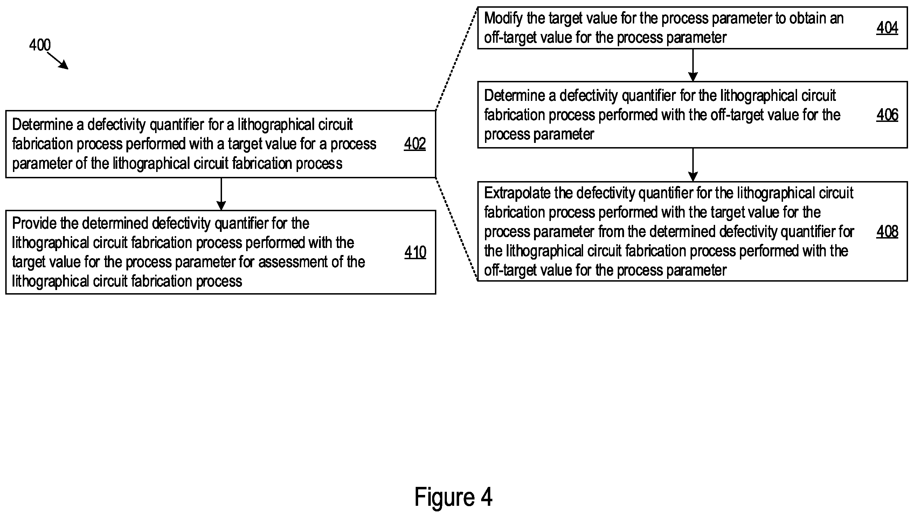

Figure 4 shows an example of logic 400 that a system may implement to support defectivity quantifier determinations through off-target process parameters for lithographical circuit fabrication processes. For example, the computing system 100 may implement the logic 400 as hardware, executable instructions stored on a machine-readable medium, or as a combination of both. The computing system 100 may implement the logic 400 via the quantifier determination engine 110 and quantifier provision engine 112, through which the computing system 100 may perform or execute the logic 400 as a method to support defectivity quantifier determinations through off-target process parameters for lithographical circuit fabrication processes. The following description of the logic 400 is provided using the quantifier determination engine 110 and quantifier provision engine 112 as examples. However, various other implementation options by systems are possible.

In implementing the logic 400, the quantifier determination engine 110 may determine a defectivity quantifier for a lithographical circuit fabrication process performed with a target value for a process parameter of the lithographical circuit fabrication process (402). The defectivity quantifier may specify a quantitative value for, as one example, a stochastic effect on the lithographical circuit fabrication process. In determining the defectivity quantifier, the quantifier determination engine 110 may modify the target value for the process parameter to obtain an off-target value for the process parameter (404), determine a defectivity quantifier for the lithographical circuit fabrication process performed with the off-target value for the process parameter (406), and extrapolate the defectivity quantifier for the lithographical circuit fabrication process performed with the target value for the process parameter from the determined defectivity quantifier for the lithographical circuit fabrication process performed with the off-target value for the process parameter (408).

In implementing the logic 400, the quantifier provision engine 112 may provide the determined defectivity quantifier for the lithographical circuit fabrication process performed with the target value for the process parameter for assessment of the lithographical circuit fabrication process (410). The quantifier provision engine 112 may do so in any of the ways described herein.

The logic 400 shown in Figure 4 provides an illustrative example by which a computing system 100 may support, implement, or provide defectivity quantifier determinations through off-target process parameters. Additional or alternative steps in the logic 400 are contemplated herein, including according to any of the defectivity quantifier determination technology described herein with regards to the quantifier determination engine 110, quantifier provision engine 112, or combinations of both.

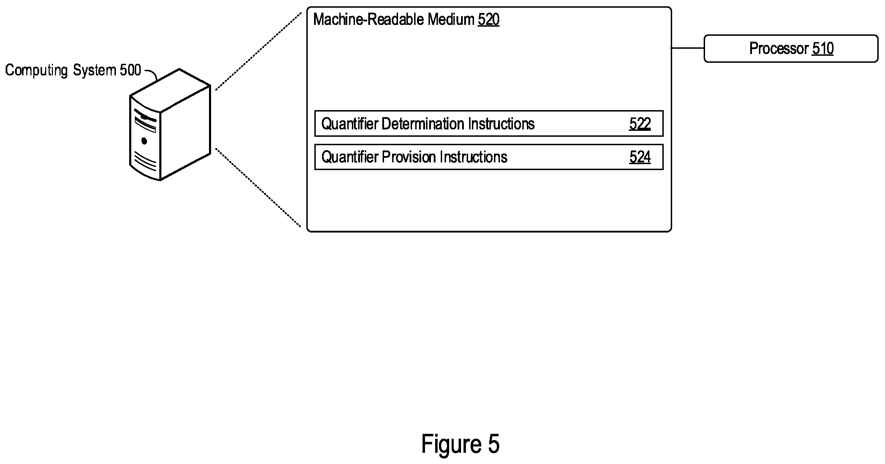

Figure 5 shows an example of a computing system 500 that supports defectivity quantifier determinations through off-target process parameters for lithographical circuit fabrication processes. The computing system 500 may include a processor 510, which may take the form of a single or multiple processors. The processor(s) 510 may include a central processing unit (CPU), microprocessor, or any hardware device suitable for executing instructions stored on a machine-readable medium. The computing system 500 may include a machine-readable medium 520. The machine-readable medium 520 may take the form of any non-transitory electronic, magnetic, optical, or other physical storage device that stores executable instructions, such as the quantifier determination instructions 522 and the quantifier provision instructions 524 shown in Figure 5. As such, the machine-readable medium 520 may be, for example, Random Access Memory (RAM) such as a dynamic RAM (DRAM), flash memory, spin-transfer torque memory, an Electrically-Erasable Programmable Read-Only Memory (EEPROM), a storage drive, an optical disk, and the like.

The computing system 500 may execute instructions stored on the machine-readable medium 520 through the processor 510. Executing the instructions (e.g., the quantifier determination instructions 522 and/or the quantifier provision instructions 524) may cause the computing system 500 to perform any of the defectivity quantifier determination features described herein, including according to any of the features of the quantifier determination engine 110, quantifier provision engine 112, or combinations of both.

For example, execution of the quantifier determination instructions 522 by the processor 510 may cause the computing system 500 to determine a defectivity quantifier for a lithographical circuit fabrication process performed with a target value for a process parameter of the lithographical circuit fabrication process, and the defectivity quantifier may specify a quantitative value for a stochastic effect on the lithographical circuit fabrication process. Execution of the quantifier determination instructions 522 may cause the computing system 500 to determine the defectivity quantifier by modifying the target value for the process parameter to obtain an off-target value for the process parameter, determining a defectivity quantifier for the lithographical circuit fabrication process performed with the off-target value for the process parameter, and extrapolating the defectivity quantifier for the lithographical circuit fabrication process performed with the target value for the process parameter from the determined defectivity quantifier for the lithographical circuit fabrication process performed with the off-target value for the process parameter. Execution of the quantifier provision instructions 524 by the processor 510 may cause the computing system 500 to provide the determined defectivity quantifier for the lithographical circuit fabrication process performed with the target value for the process parameter for assessment of the lithographical circuit fabrication process.

Any additional or alternative defectivity quantifier determination features as described herein may be implemented via the quantifier determination instructions 522, quantifier provision instructions 524, or a combination of both.

The systems, methods, devices, and logic described above, including the quantifier determination engine 110 and quantifier provision engine 112, may be implemented in many different ways in many different combinations of hardware, logic, circuitry, and executable instructions stored on a machine-readable medium. For example, the quantifier determination engine 110, quantifier provision engine 112, or combinations thereof, may include circuitry in a controller, a microprocessor, or an application specific integrated circuit (ASIC), or may be implemented with discrete logic or components, or a combination of other types of analog or digital circuitry, combined on a single integrated circuit or distributed among multiple integrated circuits. A product, such as a computer program product, may include a storage medium and machine-readable instructions stored on the medium, which when executed in an endpoint, computer system, or other device, cause the device to perform operations according to any of the description above, including according to any features of the quantifier determination engine 110, quantifier provision engine 112, or combinations thereof.

The processing capability of the systems, devices, and engines described herein, including the quantifier determination engine 110 and quantifier provision engine 112, may be distributed among multiple system components, such as among multiple processors and memories, optionally including multiple distributed processing systems or cloud/network elements. Parameters, databases, and other data structures may be separately stored and managed, may be incorporated into a single memory or database, may be logically and physically organized in many different ways, and may be implemented in many ways, including data structures such as linked lists, hash tables, or implicit storage mechanisms. Programs may be parts (e.g., subroutines) of a single program, separate programs, distributed across several memories and processors, or implemented in many different ways, such as in a library (e.g., a shared library).

While various examples have been described above, many more implementations are possible.

## Claims

1. A method comprising:
by a computing system (100, 500):
determining (402) a defectivity quantifier (310) for a lithographical circuit fabrication process performed with a target value (210) for a process parameter of the lithographical circuit fabrication process, wherein the defectivity quantifier (250, 310) specifies a quantitative value for a stochastic effect on the lithographical circuit fabrication process, and wherein determining the defectivity quantifier (310) comprises:
modifying (404) the target value (210) for the process parameter to obtain an off-target value (220) for the process parameter;
determining (406) a defectivity quantifier (250) for the lithographical circuit fabrication process performed with the off-target value (220) for the process parameter; and
determining the defectivity quantifier (310) for the lithographical circuit fabrication process performed with the target value (210) for the process parameter by extrapolating (408) from the determined defectivity quantifier (250) for the lithographical circuit fabrication process performed with the off-target value (220) for the process parameter; and
providing (410) the determined defectivity quantifier (310) for the lithographical circuit fabrication process performed with the target value (210) for the process parameter for assessment of the lithographical circuit fabrication process.

2. The method of claim 1, wherein the stochastic effect comprises a particular stochastic-induced defect in circuits manufactured via the lithographical circuit fabrication process with the target value (210) for the process parameter and wherein the defectivity quantifier (250, 310) comprises a defect probability for the particular stochastic-induced defect.

3. The method of claim 1 or 2, comprising determining the defectivity quantifier (250) for the lithographical circuit fabrication process performed with the off-target value (220) for the process parameter through stochastic simulations, experimental measurements, or a combination of both.

4. The method of any of claims 1-3, wherein modifying the target value (210) for the process parameter comprises adjusting a dose value, a focus value, a photoresist parameter values, a photomask dimension value of exposed features, or any combination thereof.

5. The method of any of claims 1-4, wherein extrapolating comprises applying a logarithmic curve-fitting extrapolation process using, as an input, the determined defectivity quantifier (250) for the lithographical circuit fabrication process performed with the off-target value (220) for the process parameter.

6. The method of any of claims 1-4, wherein extrapolating comprises applying a predetermined analytical dependence between the defectivity quantifier for the lithographical circuit fabrication process and the process parameter in order to determine the defectivity quantifier (310) for the lithographical circuit fabrication process performed with the target value (210) for the process parameter.

7. The method of any of claims 1-6, comprising modifying the target value (210) of the process parameter to increase an occurrence rate of the stochastic effect.

8. A system (100) comprising:
a quantifier determination engine (110) configured to determine a defectivity quantifier (310) for a lithographical circuit fabrication process performed with a target value (210) for a process parameter of the lithographical circuit fabrication process, wherein the defectivity quantifier (250, 310) specifies a quantitative value for a stochastic effect on the lithographical circuit fabrication process, the system (100) further comprising a computing system for:
modifying the target value (210) for the process parameter to obtain an off-target value (220) for the process parameter;
determining a defectivity quantifier (250) for the lithographical circuit fabrication process performed with the off-target value (220) for the process parameter; and
determining the defectivity quantifier (310) for the lithographical circuit fabrication process performed with the target value (210) for the process parameter by extrapolating from the determined defectivity quantifier (250) for the lithographical circuit fabrication process performed with the off-target value (220) for the process parameter; and
the system (100) further comprising a quantifier provision engine (112) configured to provide the determined defectivity quantifier (310) for the lithographical circuit fabrication process performed with the target value (210) for the process parameter for assessment of the lithographical circuit fabrication process.

9. The system (100) of claim 8, wherein the stochastic effect comprises a particular stochastic-induced defect in circuits manufactured via the lithographical circuit fabrication process with the target value (210) for the process parameter and wherein the defectivity quantifier (250, 310) comprises a defect probability for the particular stochastic-induced defect.

10. The system (100) of claim 8 or 9, wherein the quantifier determination engine (110) is configured to determine the defectivity quantifier (250) for the lithographical circuit fabrication process performed with the off-target value (220) for the process parameter through stochastic simulations, experimental measurements, or a combination of both.

11. The system (100) of any of claims 8-10, wherein the quantifier determination engine (110) is configured to modify the target value (210) for the process parameter by adjusting a dose value, a focus value, a photoresist parameter values, a photomask dimension value of exposed features, or any combination thereof.

12. The system (100) of any of claims 8-11, wherein the quantifier determination engine (110) is configured to extrapolate the defectivity quantifier (310) for the lithographical circuit fabrication process performed with the target value (210) by:
applying a logarithmic curve-fitting extrapolation process using, as an input, the determined defectivity quantifier (250) for the lithographical circuit fabrication process performed with the off-target value (220) for the process parameter.

13. The system (100) of any of claims 8-11, wherein the quantifier determination engine (110) is configured to extrapolate the defectivity quantifier (310) for the lithographical circuit fabrication process performed with the target value (210) by:
applying a predetermined analytical dependence between the defectivity quantifier for the lithographical circuit fabrication process and the process parameter in order to determine the defectivity quantifier (310) for the lithographical circuit fabrication process performed with the target value (210) for the process parameter.

14. The system (100) of any of claims 8-13, wherein the quantifier determination engine (110) is configured to modify the target value (210) of the process parameter to increase an occurrence rate of the stochastic effect.

15. A non-transitory machine-readable medium (520) comprising instructions (522, 524) that, when executed by a processor (510), cause a computing system (500) to perform a method according to any of claims 1-7.

## Patentansprüche

1. Verfahren, umfassend:
durch ein Rechensystem (100, 500):
Bestimmen (402) einer Defektivitätskennzahl (310) für ein lithografisches Schaltungsherstellungsverfahren, das mit einem Sollwert (210) für einen Verfahrensparameter des lithografischen Schaltungsherstellungsverfahrens durchgeführt wird, wobei die Defektivitätskennzahl (250, 310) einen quantitativen Wert für einen stochastischen Effekt auf das lithografische Schaltungsherstellungsverfahren angibt und wobei das Bestimmen der Defektivitätskennzahl (310) umfasst:
Modifizieren (404) des Sollwerts (210) für den Verfahrensparameter, um eine Sollwertabweichung (220) für den Verfahrensparameter zu erhalten;
Bestimmen (406) einer Defektivitätskennzahl (250) für das lithografische Schaltungsherstellungsverfahren, das mit der Sollwertabweichung (220) für den Verfahrensparameter durchgeführt wird; und
Bestimmen der Defektivitätskennzahl (310) für das lithografische Schaltungsherstellungsverfahren, das mit dem Sollwert (210) für den Verfahrensparameter durchgeführt wird, durch Extrapolieren (408) von der bestimmten Defektivitätskennzahl (250) für das lithografische Schaltungsherstellungsverfahren, das mit der Sollwertabweichung (220) für den Verfahrensparameter durchgeführt wird; und
Bereitstellen (410) der bestimmten Defektivitätskennzahl (310) für das lithografische Schaltungsherstellungsverfahren, das mit dem Sollwert (210) für den Verfahrensparameter durchgeführt wird, zur Bewertung des lithografischen Schaltungsherstellungsverfahrens.

2. Verfahren nach Anspruch 1, wobei der stochastische Effekt einen bestimmten stochastisch induzierten Defekt in Schaltungen, die durch das lithografische Schaltungsherstellungsverfahren mit dem Sollwert (210) für den Verfahrensparameter hergestellt wurden, umfasst, und wobei die Defektivitätskennzahl (250, 310) eine Defektwahrscheinlichkeit für den bestimmten stochastisch induzierten Defekt umfasst.

3. Verfahren nach Anspruch 1 oder 2, umfassend das Bestimmen der Defektivitätskennzahl (250) für das lithografische Schaltungsherstellungsverfahren, das mit der Sollwertabweichung (220) für den Verfahrensparameter durchgeführt wird, durch stochastische Simulationen, experimentelle Messungen oder eine Kombination aus beidem.

4. Verfahren nach einem der Ansprüche 1-3, wobei das Modifizieren des Sollwerts (210) für den Verfahrensparameter das Anpassen eines Dosiswerts, eines Fokuswerts, eines Fotolack-Parameterwerts, eines Photomasken-Dimensionswerts belichteter Merkmale oder einer beliebigen Kombination davon umfasst.

5. Verfahren nach einem der Ansprüche 1-4, wobei das Extrapolieren das Anwenden eines Extrapolationsverfahrens mit logarithmischer Kurvenanpassung umfasst, unter Verwendung, als Eingabe, der bestimmten Defektivitätskennzahl (250) für das lithografische Schaltungsherstellungsverfahren, das mit der Sollwertabweichung (220) für den Verfahrensparameter durchgeführt wird.

6. Verfahren nach einem der Ansprüche 1-4, wobei das Extrapolieren das Anwenden einer vorbestimmten analytischen Abhängigkeit zwischen der Defektivitätskennzahl für das lithografische Schaltungsherstellungsverfahren und dem Verfahrensparameter umfasst, um die Defektivitätskennzahl (310) für das lithografische Schaltungsherstellungsverfahren, die mit dem Sollwert (210) für den Verfahrensparameter durchgeführt wird, zu bestimmen.

7. Verfahren nach einem der Ansprüche 1-6, umfassend das Modifizieren des Sollwerts (210) des Verfahrensparameters, um eine Häufigkeit des Auftretens des stochastischen Effekts zu erhöhen.

8. System (100), umfassend:
eine Kennzahlbestimmungs-Engine (110), die ausgelegt ist zum Bestimmen einer Defektivitätskennzahl (310) für ein lithografisches Schaltungsherstellungsverfahren, das mit einem Sollwert (210) für einen Verfahrensparameter des lithografischen Schaltungsherstellungsverfahrens durchgeführt wird, wobei die Defektivitätskennzahl (250, 310) einen quantitativen Wert für einen stochastischen Effekt auf das lithografische Schaltungsherstellungsverfahren angibt, wobei das System (100) ferner ein Rechensystem umfasst zum:
Modifizieren des Sollwerts (210) für den Verfahrensparameter, um eine Sollwertabweichung (220) für den Verfahrensparameter zu erhalten; Bestimmen einer Defektivitätskennzahl (250) für das lithografische Schaltungsherstellungsverfahren, das mit der Sollwertabweichung (220) für den Verfahrensparameter durchgeführt wird; und
Bestimmen der Defektivitätskennzahl (310) für das lithografische Schaltungsherstellungsverfahren, das mit dem Sollwert (210) für den Verfahrensparameter durchgeführt wird, durch Extrapolieren von der bestimmten Defektivitätskennzahl (250) für das lithografische Schaltungsherstellungsverfahren, das mit der Sollwertabweichung (220) für den Verfahrensparameter durchgeführt wird; und
wobei das System (100) ferner eine Kennzahlbereitstellungs-Engine (112) umfasst, die ausgelegt ist zum Bereitstellen der bestimmten Defektivitätskennzahl (310) für das lithografische Schaltungsherstellungsverfahren, das mit dem Sollwert (210) für den Verfahrensparameter durchgeführt wird, zur Bewertung des lithografischen Schaltungsherstellungsverfahrens.

9. System (100) nach Anspruch 8, wobei der stochastische Effekt einen bestimmten stochastisch induzierten Defekt in Schaltungen umfasst, die durch das lithografische Schaltungsherstellungsverfahren mit dem Sollwert (210) für den Verfahrensparameter hergestellt wurden, und wobei die Defektivitätskennzahl (250, 310) eine Defektwahrscheinlichkeit für den bestimmten stochastisch induzierten Defekt umfasst.

10. System (100) nach Anspruch 8 oder 9, wobei die Kennzahlbestimmungs-Engine (110) ausgelegt ist zum Bestimmen der Defektivitätskennzahl (250) für das lithografische Schaltungsherstellungsverfahren, das mit der Sollwertabweichung (220) für den Verfahrensparameter durchgeführt wird, durch stochastische Simulationen, experimentelle Messungen oder eine Kombination aus beidem.

11. System (100) nach Anspruch 8-10, wobei die Kennzahlbestimmungs-Engine (110) ausgelegt ist zum Modifizieren des Sollwerts (210) für den Verfahrensparameter durch Anpassen eines Dosiswerts, eines Fokuswerts, eines Fotolack-Parameterwerts, eines Photomasken-Dimensionswerts belichteter Merkmale oder einer beliebigen Kombination davon.

12. System (100) nach einem der Ansprüche 8-11, wobei die Kennzahlbestimmungs-Engine (110) ausgelegt ist zum Extrapolieren der Defektivitätskennzahl (310) für das mit dem Sollwert (210) durchgeführte lithografische Schaltungsherstellungsverfahren durch:
Anwenden eines Extrapolationsverfahrens mit logarithmischer Kurvenanpassung, unter Verwendung, als Eingabe, der bestimmten Defektivitätskennzahl (250) für das lithografische Schaltungsherstellungsverfahren, das mit der Sollwertabweichung (220) für den Verfahrensparameter durchgeführt wird.

13. System (100) nach einem der Ansprüche 8-11, wobei die Kennzahlbestimmungs-Engine (110) ausgelegt ist zum Extrapolieren der Defektivitätskennzahl (310) für das mit dem Sollwert (210) durchgeführte lithografische Schaltungsherstellungsverfahren durch:
Anwenden einer vorbestimmten analytischen Abhängigkeit zwischen der Defektivitätskennzahl für das lithografische Schaltungsherstellungsverfahren und dem Verfahrensparameter umfasst, um die Defektivitätskennzahl (310) für das lithografische Schaltungsherstellungsverfahren, das mit dem Sollwert (210) für den Verfahrensparameter durchgeführt wird, zu bestimmen.

14. System (100) nach einem der Ansprüche 8-13, wobei die Kennzahlbestimmungs-Engine (110) ausgelegt ist zum Modifizieren des Sollwerts (210) des Verfahrensparameters, um eine Häufigkeit des Auftretens des stochastischen Effekts zu erhöhen.

15. Nichtflüchtiges maschinenlesbares Medium (520), das Anweisungen (522, 524) umfasst, die, wenn sie durch einen Prozessor (510) ausgeführt werden, ein Rechensystem (500) dazu veranlassen, ein Verfahren nach einem der Ansprüche 1-7 durchzuführen.

## Revendications

1. Procédé comprenant :
par un système informatique (100, 500) :
la détermination (402) d'un quantificateur de détectivité (310) pour un processus de fabrication de circuits lithographiques réalisé avec une valeur cible (210) pour un paramètre de processus du processus de fabrication de circuits lithographiques, dans lequel le quantificateur de défectivité (250, 310) spécifie une valeur quantitative pour un effet stochastique sur le processus de fabrication de circuits lithographiques, et dans lequel la détermination du quantificateur de défectivité (310) comprend :
la modification (404) de la valeur cible (210) pour le paramètre de processus pour obtenir une valeur hors cible (220) pour le paramètre de processus ;
la détermination (406) d'un quantificateur de défectivité (250) pour le processus de fabrication de circuits lithographiques réalisé avec la valeur hors cible (220) pour le paramètre de processus ; et
la détermination du quantificateur de défectivité (310) pour le processus de fabrication de circuits lithographiques réalisé avec la valeur cible (210) pour le paramètre de processus par extrapolation (408) à partir du quantificateur de défectivité (250) déterminé pour le processus de fabrication de circuits lithographiques réalisé avec la valeur hors cible (220) pour le paramètre de processus ; et
la fourniture (410) du quantificateur de défectivité (310) déterminé pour le processus de fabrication de circuits lithographiques réalisé avec la valeur cible (210) pour le paramètre de processus pour une évaluation du processus de fabrication de circuits lithographiques.

2. Procédé selon la revendication 1, dans lequel l'effet stochastique comprend un défaut induit de manière stochastique particulier dans des circuits manufacturés par l'intermédiaire du processus de fabrication de circuits lithographiques avec la valeur cible (210) pour le paramètre de processus et dans lequel le quantificateur de défectivité (250, 310) comprend une probabilité de défaut pour le défaut induit de manière stochastique particulier.

3. Procédé selon la revendication 1 ou la revendication 2, comprenant la détermination du quantificateur de défectivité (250) pour le processus de fabrication de circuits lithographiques réalisé avec la valeur hors cible (220) pour le paramètre de processus par le biais de simulations stochastiques, de mesures expérimentales, ou d'une combinaison des deux.

4. Procédé selon l'une quelconque des revendications 1 à 3, dans lequel la modification de la valeur cible (210) pour le paramètre de processus comprend le réglage d'une valeur de dose, d'une valeur de mise au point, de valeurs de paramètres de résine photosensible, d'une valeur de dimension de masque photographique de caractéristiques exposées, ou d'une combinaison quelconque de ces dernières.

5. Procédé selon l'une quelconque des revendications 1 à 4, dans lequel l'extrapolation comprend l'application d'un processus d'extrapolation d'ajustement de courbe logarithmique en utilisant, comme entrée, le quantificateur de défectivité (250) déterminé pour le processus de fabrication de circuits lithographiques réalisé avec la valeur hors cible (220) pour le paramètre de processus.

6. Procédé selon l'une quelconque des revendications 1 à 4, dans lequel l'extrapolation comprend l'application d'une dépendance analytique prédéterminée entre le quantificateur de défectivité pour le processus de fabrication de circuits lithographiques et le paramètre de processus afin de déterminer le quantificateur de défectivité (310) pour le processus de fabrication de circuits lithographiques réalisé avec la valeur cible (210) pour le paramètre de processus.

7. Procédé selon l'une quelconque des revendications 1 à 6, comprenant la modification de la valeur cible (210) du paramètre de processus pour augmenter un taux d'occurrence de l'effet stochastique.

8. Système (100) comprenant :
un moteur de détermination de quantificateur (110) configuré pour déterminer un quantificateur de défectivité (310) pour un processus de fabrication de circuits lithographiques réalisé avec une valeur cible (210) pour un paramètre de processus du processus de fabrication de circuits lithographiques, dans lequel le quantificateur de défectivité (250, 310) spécifie une valeur quantitative pour un effet stochastique sur le processus de fabrication de circuits lithographiques, le système (100) comprenant en outre un système informatique pour :
modifier la valeur cible (210) pour le paramètre de processus pour obtenir une valeur hors cible (220) pour le paramètre de processus ;
déterminer un quantificateur de défectivité (250) pour le processus de fabrication de circuits lithographiques réalisé avec la valeur hors cible (220) pour le paramètre de processus ; et
déterminer le quantificateur de défectivité (310) pour le processus de fabrication de circuits lithographiques réalisé avec la valeur cible (210) pour le paramètre de processus par extrapolation à partir du quantificateur de défectivité (250) déterminé pour le processus de fabrication de circuits lithographiques réalisé avec la valeur hors cible (220) pour le paramètre de processus ; et
le système (100) comprend en outre un moteur de fourniture de quantificateur (112) configuré pour fournir le quantificateur de défectivité (310) déterminé pour le processus de fabrication de circuits lithographiques réalisé avec la valeur cible (210) pour le paramètre de processus pour une évaluation du processus de fabrication de circuits lithographiques.

9. Système (100) selon la revendication 8, dans lequel l'effet stochastique comprend un défaut induit de manière stochastique particulier dans des circuits manufacturés par l'intermédiaire du processus de fabrication de circuits lithographiques avec la valeur cible (210) pour le paramètre de processus et dans lequel le quantificateur de défectivité (250, 310) comprend une probabilité de défaut pour le défaut induit de manière stochastique particulier.

10. Système (100) selon la revendication 8 ou la revendication 9, dans lequel le moteur de détermination de quantificateur (110) est configuré pour déterminer le quantificateur de défectivité (250) pour le processus de fabrication de circuits lithographiques réalisé avec la valeur hors cible (220) pour le paramètre de processus par le biais de simulations stochastiques, de mesures expérimentales, ou d'une combinaison des deux.

11. Système (100) selon l'une quelconque des revendications 8 à 10, dans lequel le moteur de détermination de quantificateur (110) est configuré pour modifier la valeur cible (210) pour le paramètre de processus par réglage d'une valeur de dose, d'une valeur de mise au point, de valeurs de paramètres de résine photosensible, d'une valeur de dimension de masque photographique de caractéristiques exposées, ou d'une combinaison quelconque de ces dernières.

12. Système (100) selon l'une quelconque des revendications 8 à 11, dans lequel le moteur de détermination de quantificateur (110) est configuré pour extrapoler le quantificateur de défectivité (310) pour le processus de fabrication de circuits lithographiques réalisé avec la valeur cible (210) par :
application d'un processus d'extrapolation logarithmique d'ajustement de courbe en utilisant, comme entrée, le quantificateur de défectivité (250) déterminé pour le processus de fabrication de circuits lithographiques réalisé avec la valeur hors cible (220) pour le paramètre de processus.

13. Système (100) selon l'une quelconque des revendications 8 à 11, dans lequel le moteur de détermination de quantificateur (110) est configuré pour extrapoler le quantificateur de défectivité (310) pour le processus de fabrication de circuits lithographiques réalisé avec la valeur cible (210) par :
application d'une dépendance analytique prédéterminée entre le quantificateur de défectivité pour le processus de fabrication de circuits lithographiques et le paramètre de processus afin de déterminer le quantificateur de défectivité (310) pour le processus de fabrication de circuits lithographiques réalisé avec la valeur cible (210) pour le paramètre de processus.

14. Système (100) selon l'une quelconque des revendications 8 à 13, dans lequel le moteur de détermination de quantificateur (110) est configuré pour modifier la valeur cible (210) du paramètre de processus pour augmenter un taux d'occurrence de l'effet stochastique.

15. Support non transitoire lisible par machine (520) comprenant des instructions (522, 524) qui, lorsqu'elles sont exécutées par un processeur (510), amènent un système informatique (500) à réaliser un procédé selon l'une quelconque des revendications 1 à 7.
